# EUROPEAN PATENT APPLICATION

(11) **EP 4 156 304 A1**
(43) Date of publication of application: **29.03.2023**
(21) Application number: 21199433.0
(22) Date of filing: 28.09.2021
(51) Int. Cl.: H01L 29/872, H01L 29/78, H01L 21/329, H01L 21/336, H01L 29/16, H01L 29/47, H01L 21/04

(54) **SILICON CARBIDE SEMICONDUCTOR DEVICE AND MANUFACTURING METHOD**

(71) Applicant: Hitachi Energy Switzerland AG, 5400 Baden (CH)
(72) Inventor: Alfieri, Giovanni, 5103 Möriken (CH); Knoll, Lars, 5607 Hägglingen (CH)
(74) Representative: Epping - Hermann - Fischer

(57) **Abstract**

The present disclosure relates to a power semiconductor device (100) comprising a silicon carbide semiconductor, SiC, structure (110) comprising a SiC epilayer (112), at least one ohmic contact (120) formed on a first main surface (114) of the SiC structure (110), and at least Schottky barrier contact (130) formed on a second main surface (116) of the SiC structure (110). The at least one Schottky barrier contact (130) comprises a metal layer (136) and a carbon group interlayer (134) arranged between the metal layer (136) and the second main surface (116) of the SiC structure (110).

The present disclosure relates to a Schottky barrier diode (400), a vertical field effect transistor, such as a power MOSFET (500), and a method for manufacturing a power semiconductor device (100).

## Description

The present disclosure relates to a power semiconductor device comprising a silicon carbide semiconductor structure with at least one ohmic contact and at least one Schottky barrier contact, such as a Schottky barrier diode or a vertical FET, and methods for their manufacture.

Silicon carbide (SiC) semiconductor Schottky barrier diodes (SBD) generally have a low leakage current, forward voltage drop and reverse recovery time, and are therefore suitable for many application areas, such as automotive applications, including charging of electric vehicles, renewable energy generation and distribution, and others.

A SiC SBD may be formed by metallization of a SiC semiconductor structure in a two-step process. First, a low contact resistance, ohmic contact is deposited on a SiC substrate and then sintered at a relatively high temperature of 900 to 1000°C. In a subsequent, second step, a Nickel (Ni) layer is deposited on an epilayer of the SiC semiconductor structure in order to obtain a Schottky barrier contact on an opposite side.

It is an aim of the present disclosure to show alternative, preferably more efficient manufacturing methods for forming power semiconductor device comprising a SiC structure and corresponding power semiconductor devices. In particular, it would be desirable to describe power semiconductor devices that are less susceptible to adverse conditions during their manufacture, thus enabling an improved manufacturing process. Embodiments of the disclosure relate to a power semiconductor device comprising a SiC structure, a Schottky barrier diode, a vertical field effect transistor, and a method for manufacturing a power semiconductor device according to the independent claims.

According to a first aspect of the disclosure, a power semiconductor device is disclosed. The device comprises a silicon carbide semiconductor (SiC) structure, comprising a SiC layer, at least one ohmic contact formed on a first main surface of the SiC structure, and at least one Schottky barrier contact formed on a second main surface of the SiC structure. The at least one Schottky barrier contact comprises a metal layer and a carbon group interlayer arranged between the metal layer and the second main surface of the SiC structure.

Among others, the inventors have found that a Schottky barrier contact comprising a stack including a carbon group interlayer and a metal layer does not degrade at higher temperatures, for example, at an annealing temperature of about 1000°C. Accordingly, the resistance of the Schottky barrier contact to adverse conditions during semiconductor device manufacturing is reduced, allowing, amongst other advantages, the simultaneous formation of the at least one ohmic contact and the at least one Schottky barrier contact.

According to at least one embodiment, the SiC layer is a semi-conductive SiC layer having a dopant concentration below 10¹⁷ cm^{―3}, in particular in the range of 10¹³ cm^{―3} to 10¹⁷ cm^{―3}_{.} For example, an epitaxially grown SiC layer may be doped with 3·10¹⁴ cm^{―3} to 5·10¹⁴ cm^{―3} nitrogen atoms. Alternatively, the SiC layer may be a high purity semi-insulating SiC layer having an electrical resistivity of 10⁷ to 10⁹ Ohm cm. Among other advantages, the inventors have found that a SiC layer having a relatively low dopant concentration is a suitable foundation for the above stack in that such a low dopant concentration SiC layer does not react with the materials of the Schottky barrier contact during annealing and similar high temperature processing steps.

According to at least one embodiment, the carbon group interlayer may have a thickness in the range between 10 to 100 nm. Such a thickness is sufficient to achieve an improved thermal stability of the Schottky barrier contact and, at the same time, maintain the desired Schottky barrier formation.

According to a second aspect of the disclosure, a Schottky barrier diode is provided. The Schottky barrier diode comprises the power semiconductor device according to the first aspect, an anode terminal connected to the at least one Schottky barrier contact, and a cathode terminal connected to the at least one ohmic contact.

Such a Schottky barrier diode is easy to manufacture, has a relatively low leakage current, low forward voltage drop and a low reverse recovery time.

According to a third aspect of the disclosure, a vertical field effect transistor (FET), in particular a power MOSFET, is provided. The vertical FET comprises a power semiconductor device according to the first aspect, a source terminal connected to the at least one Schottky barrier contact, a drain terminal connected to the at least one ohmic contact, and a gate terminal connected to an insulated gate electrode arranged on the second main surface of the SiC structure.

In such a vertical FET with a built-in body diode, no additional device is required to serve as a freewheeling diode. Integration of the Schottky diode into the vertical FET is enabled by the increased thermal budget of the above Schottky contact. Moreover, integrating a Schottky diode into a MOSFET or a similar power semiconductor structure is one option to reduce a turn-on voltage of the body diode from more than 2.5 V to below 1 V.

According to a fourth aspect of the disclosure, a method for manufacturing a power semiconductor device is provided. The method comprises the steps of:
- forming, in particular epitaxially growing, a silicon carbide, SiC, layer of a SiC structure;
- depositing a carbon group interlayer on the SiC layer;
- depositing a first metal layer on a backside of the SiC structure;
- depositing a second metal layer of a Schottky contact on the carbon group interlayer; and
- after depositing the first and second metal layers, annealing at least the first metal layer at an annealing temperature to form at least one ohmic contact.

The above method steps enable the formation of ohmic and Schottky barrier contacts in the same process step and at the same temperature. The disclosed method increases a thermal budget of the formed Schottky barrier contact and reduces the integration effort significantly. It also allows other high temperature steps to be performed after formation of the Schottky barrier contact.

The above power semiconductor device and method for forming the same are particularly suitable for the manufacturing of Schottky barrier diodes, vertical FETs and other semiconductor devices comprising at least one Schottky barrier contact structure.

Features and advantages described in connection with the power semiconductor device in general and the Schottky barrier diode or the vertical FET in particular can therefore be used in any of the disclosed devices. Moreover, specific aspects, such as the choice of materials, dimensions or similar parameters disclosed with respect to the various devices are also applicable to the corresponding steps of the manufacturing method and vice versa.

The accompanying figures are included to provide further understanding. In the figures, elements of the same structure and/or functionality may be referenced by the same or corresponding reference signs. It is to be understood that the embodiments shown in the figure are illustrative representations and are not necessarily drawn to scale.
Figure 1 shows a schematic cross-section through a power semiconductor device.
Figure 2 shows a schematic flow chart of steps of a method for manufacturing a power semiconductor device.
Figure 3 shows the current-over-voltage (I-V) characteristics of a Schottky barrier contact before and after annealing with different annealing temperatures.

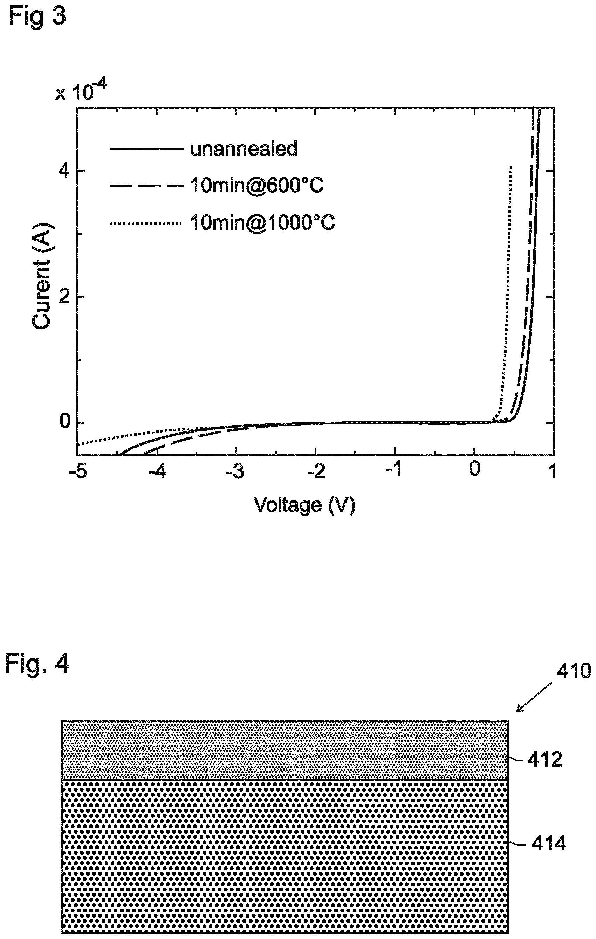

Figures 3 to 6 show different processing stages during manufacturing a Schottky barrier diode.

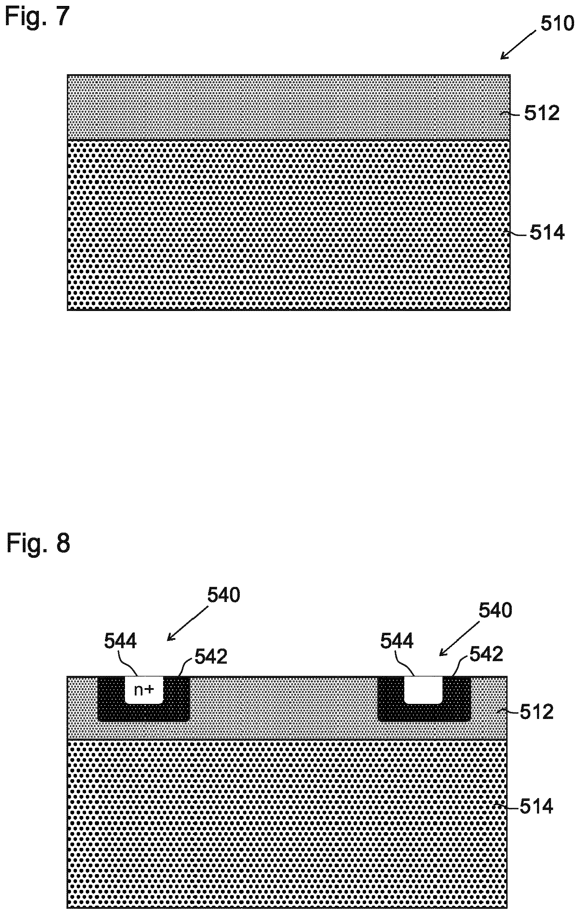

Figures 7 to 10 show various processing stages during manufacturing of a vertical power MOSFET.

While the disclosure is amenable to various modifications and alternative forms, specifics thereof have been shown by way of example in the figures and will be described in detail. It should be understood, however, that the intention is not to limit the disclosure to the particular embodiments described. On the contrary, the intention is to cover all modifications, equivalents, and alternatives falling within the scope of the disclosure defined by the appended claims.

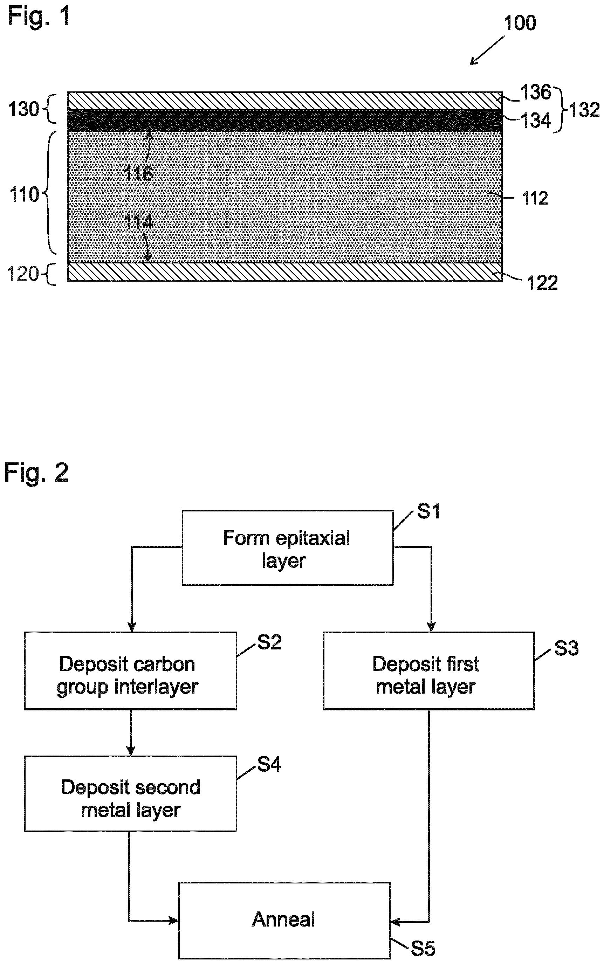

Figure 1 shows a first embodiment of a power semiconductor device 100. The device 100 comprises a SiC structure 110 comprising a SiC layer 112 having a first, in Figure 1 lower, main surface 114 and an opposite, in Figure 1 upper, second main surface 116. In the described embodiment, the SiC layer 112 extends all the way from the first main surface 114 to the second main surface 116. That is to say, the SiC structure 110 corresponds to the SiC layer 112. However, in other embodiments, the SiC layer 112 may be an epitaxial SiC layer (SiC epilayer) grown on a SiC substrate (not shown). That is to say, the SiC structure 110 comprises the SiC substrate and the SiC epilayer. In this case, the first main surface 114 is formed by the backside of the SiC substrate.

In the depicted embodiment, the power semiconductor device 100 further comprises an ohmic contact 120 formed on the first main surface 114. For example, a first metal layer 122, such as a nickel layer, may be deposited on the lower main surface 114 and may then be sintered and/or annealed to form the ohmic contact 120.

In case the SiC layer 112 extends all the way from the first main surface 114 to the second main surface 116, prior to formation of the at least one ohmic contact 120, an n+ layer or n+ region may be formed at least at a corresponding area of the first main surface 114 by ion implantation or plasma immersion ion implantation (PIII), followed by a high temperature activation at 1600 °C.

The power semiconductor device 100 further comprises a layer stack 132 comprising an interlayer 134 and a second metal layer 136 formed on top of the interlayer 134. The layer stack 132 forms a Schottky barrier contact 130 on the second main surface 116 of the underlying SiC layer 112. For this purpose, a suitable metal material, for example a nickel (Ni), can be used to form a Schottky barrier with respect to the band structure of the semiconductor material of the SiC layer 112.

To make the second metal layer 136 more resilient to higher temperatures, for example during annealing of the ohmic contact 120, the interlayer 134 comprises a suitable material, in particular a material from the carbon group (also referred to as IUPAC group 14 or Group IV), comprising elements with four valence electrons. In the described embodiment, carbon (C) is used for the interlayer 134. Alternatively, other carbon group materials having a relatively high melting point, such as silicon (Si), germanium (Ge) or lead (Pb) may be used.

The presence of the interlayer 134 prevents a direct contact between the material of the second metal layer 136 and the layer 112. Accordingly, no chemical reactions take place at the interface between the SiC structure 110 and the Schottky barrier contact 130 formed on its second surface 116 during higher temperatures, for example during annealing of the ohmic contact 120.

Figure 2 shows, in a schematic manner, steps of a method for manufacturing a power conversion device, such as the power semiconductor device 100 of Figure 1.

In a first step S1, a SiC layer 112 is epitaxially grown on a suitable substrate to form a SiC structure 110. In the described embodiment, the epitaxial SiC layer 112 is doped with a suitable dopant at a relatively low concentration of below 10¹⁷ cm^{―3} or even below 10¹⁷ cm^{―3}_{.} For example, the epitaxial SiC layer 112 may be doped with nitrogen (N) at a concentration of 3·10¹⁴ cm^{―3} to 5·10¹⁴ cm^{―3}_{.} The thickness of the SiC layer 112 is determined by the desired function, voltage and/or current class of the semiconductor device 100 and may lie in the range of may lie in the range several microns to tenth of microns, for example 5 to 15 µm.

In a further step S2, an interlayer 134 is deposited on the SiC layer 112, forming one of the main surfaces, e.g. the second surface 116 shown in Figure 1, of the SiC structure 110. The interlayer 134 is formed by depositing chemical elements from the carbon group.

In a further step S3, which may be performed at any stage of the manufacturing process after step S1 and before an annealing step S5, a conductive layer is deposited on the opposite side of the SiC structure 110. In the described example, a first metal layer 122 is deposited on the backside of the semiconductor device. For example, 100 nm of nickel may be deposited on a SiC substrate carrying the epitaxial SiC layer 112. Alternatively, different methods or materials for forming an ohmic contact may be used. For example, instead of nickel, titanium aluminum or titanium aluminum nickel alloys may be deposited, e.g. by firstly depositing titanium, then aluminum, and, optionally, nickel, and heating the resulting metal stack, for example at a temperature of 1000 °C, to form a corresponding alloy. Similarly, silver paste may be employed as ohmic contact on the backside of the substrate.

In a further step S4, which may be performed at any stage of the manufacturing process after step S2 and before the annealing step S5, a metal suitable to form a Schottky barrier contact 130 is deposited on the interlayer 134. For example, 10 to 100 nm of nickel may be deposited in a second metal layer 136 on top of the interlayer 134.

In a further step S5, at least parts of the power semiconductor device 100 are annealed. The annealing step S5 may comprise sintering and/or rapid thermal annealing (RTA) performed at a temperature in excess of 600°C. Attention is drawn to the fact that at this stage, both surfaces of the semiconductor device 100 are covered with a metal layer 122 and 136, respectively. Thus, the first metal layer 122 as well the second metal layer 136 deposited in steps S3 and S4 are subjected to the same thermal treatment. For example, both surfaces may be sintered for 10 minutes in either a vacuum or an ambient atmosphere comprising a protective gas such as argon, by RTA. As a consequence, an ohmic contact 120 is formed on the backside of the semiconductor device 110. However, due to the presence of the interlayer 134, the layer stack 132 comprising the second metal layer 136 maintains its function as a Schottky barrier contact 130.

Figure 3 shows the electrical characteristic of a power semiconductor device 100 during and after manufacturing according to the method of Figure 2. In particular, the solid line of Figure 3 shows the current-over-voltage (I-V) characteristic of a power semiconductor device 100 before the annealing in step S5. The dashed and dotes lines show the I-V characteristics of the device 100 after 10 minutes of annealing at 600°C and 1000 °C, respectively.

As shown in Figure 3, not much difference is visible in the I-V curves of the unannealed structure and the semiconductor device 100 annealed at 600 °C. That is to say, in the specific configuration of a nickel and carbon layer stack 132, annealing at a temperature of 600 °C has only limited impact, both on the formation of an ohmic contact 120 as well as the formation of a Schottky barrier contact 130.

As shown by the dotted curve of Figure 3, a lower leakage voltage and forward voltage drop can be observed for the power semiconductor device 100 annealed at 1000 °C. It is noted that this effect was also observed for lower annealing temperatures. For example, for the described nickel/carbon layer stack 132 on the described SiC structure 110, a significant lower leakage voltage and forward voltage drop were observed at an annealing temperature in excess of 800 °C.

In the investigated power semiconductor device 100, the Schottky barrier height Φ_{B} before annealing was approximately 1.5 eV (obtained by analysis of its C-V characteristics, not shown). In contrast, the power semiconductor device 100 annealed at a temperature of 600 °C had a Schottky barrier height Φ_{B} of 1.45 eV and the power semiconductor device 100 annealed at 1000 °C had a Schottky barrier height Φ_{B} of 1.8 eV. That is to say, by also annealing the layer stack 132 comprising the interlayer 134 and the metal layer 136, the Schottky behaviour of the formed power semiconductor device 100 was improved compared to the non-annealed state.

In the following, processes for the manufacturing of different power semiconductor devices comprising at least one Schottky barrier junction are described. In particular, Figures 4 to 6 describe the fabrication of a Schottky barrier diode and Figures 7 to 10 describe the manufacturing of a vertical power MOSFET.

Figure 4 shows the initial stage of production of a Schottky barrier diode, starting from a SiC structure 410. The SiC structure 410 comprises a substrate with an epilayer. In particular a 4H-SiC n-type epilayer 412 is grown on a SiC substrate 414. In the described embodiment, the SiC substrate 414 has a relatively high concentration of a dopant, like nitrogen (N), of about 10¹⁸ cm^{―3}_{.} In comparison, the n―type SiC epilayer 412 has a relatively low dopant concentration of 10¹⁴ cm^{―3} to 10¹⁶ cm^{―3}_{.} The thickness of the n-type epilayer 412 may lie in the range of 5 to 15 µm.

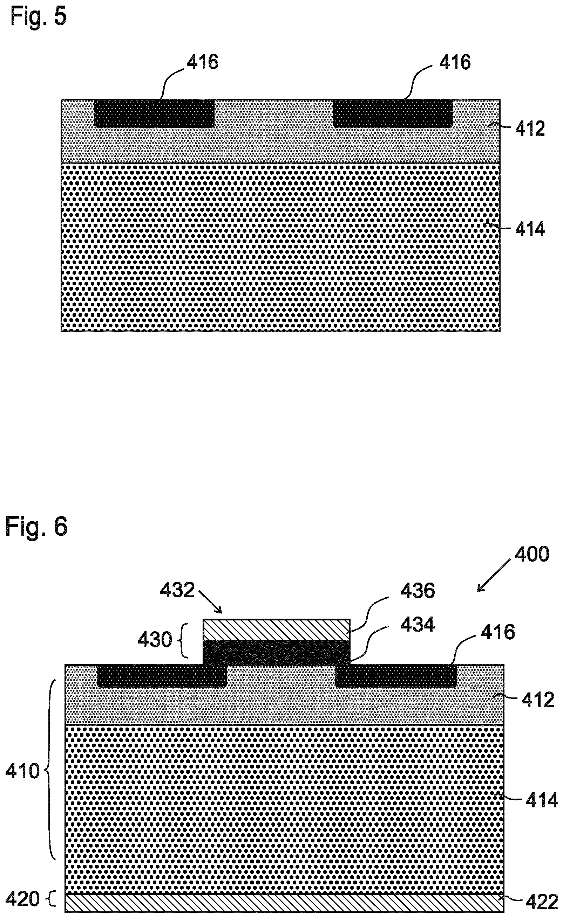

Figure 5 shows the formation of edge terminations areas 416 within the n-type SiC epilayer 412. The edge termination areas 416 are formed, for example, by ion implantation or plasma immersion ion implantation (PIII) of p-dopants in the n-type epilayer 412. If desired, deep implantation of dopants can be achieved, for example using pre-amorphization. Dopant implantation is followed by a high temperature annealing step for activation. For example, the activation may take place at a temperature in access of 1600 °C. In the described embodiment, prior to annealing, the surface of the n-type epilayer 412 is protected, for example, by a graphite cap or by a layer of diamond-like carbon (DLC), which is not shown in Figure 5. After the high temperature annealing, the graphite cap is removed, for example by O₂ ashing.

Figure 6 shows the formation of different contacts on both main surface of the SiC structure 410. On the SiC substrate 414, a metal layer 422 is deposited by electron beam (e-beam) or thermal evaporation deposition. For example, a nickel layer having a thickness of about 100 nm may be deposited on the backside of the SiC structure 410. On the opposite side of the SiC structure 410, i.e. on the surface of the SiC epilayer 412, a layer stack 432 comprising an interlayer 434 and a further metal layer 436 is formed. For example, an interlayer 434 of 10 to 100 nm of carbon may be deposited first, before a layer of 50 to 100 nm of nickel is deposited on its top. As shown in Fig. 6, the edge termination areas 416 may limit the horizontal extent of the layers 434 and 436 to a central area of the epilayer 412.

Both metal layers 422 and 436 are then annealed using rapid thermal processing (RTP). For example, the SiC structure 410 with all deposited layers may be treated at a temperature at or above 800 °C for 1 to 10 minutes or even longer. As a consequence, on the backside of the substrate 414, an ohmic contact 420 is formed. Opposite, on the n-type SiC epilayer 412, a Schottky contact 430 of the Schottky barrier diode 400 is formed or improved.

Figure 7 shows a SiC structure 510 for the formation of a vertical power MOSFET. The SiC structure 510 comprises a SiC substrate 514 and an n-type SiC epilayer 512 similar to those described above with respect to Figure 4.

Figure 8 shows the SiC structure 510 after the formation of highly doped wells in a source area 540 of the MOSFET. In particular, two p+ wells 542 are formed in the n-type SiC epilayer 512. The p+ wells 542 may have a doping concentration in access of 10¹⁶ cm^{―3}_{.} Within each of the p+ wells 542, an n+ well 544 is formed, for example, by ion implantation or plasma immersion ion implantation. The n+ wells 544 also have a relatively high dopant concentration, for example in access of 10¹⁶ cm^{―3}_{.} In the described embodiment, the surface of the SiC structure 510 is then protected, for example, by a graphite cap or DLC layer, before the source structures 540 formed by the wells 542 and 544 are activated at high temperatures. After activation, the graphite cap is removed by plasma etching.

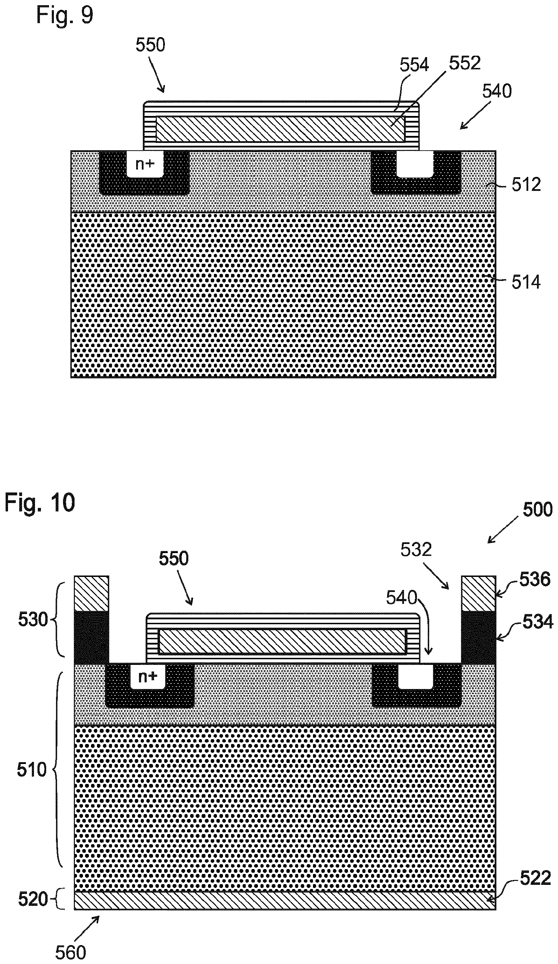

Figure 9 shows the formation of a gate structure 550. In particular, a metal gate electrode 552 may be formed between layers of a dielectric material, forming an interlayer dielectric 554 surrounding the gate electrode 552 on all sides.

Figure 10 shows the formation of an ohmic contact 520 and a Schottky contact 530 on the SiC structure 510. As described above with regard to Figure 6, the ohmic contact 520 may be formed by depositing a suitable ohmic contact metal material, such as nickel (Ni), to form a metal layer 522 on the backside of the substrate 514. The Schottky barrier contact 530 may be formed by a layer stack 532 comprising a suitable Schottky metal layer 536, such as nickel (Ni), gold (Au), molybdenum (Mo), titanium (Ti), or platinum (Pt), on a carbon group interlayer 534. Contrary to the situation depicted in Figure 6, where the Schottky barrier contact 430 is formed in a central area of the SiC structure 410 between the two-edge termination areas 416, in the embodiment shown in Figure 10, two Schottky contacts 530 are formed adjacent to the p+ wells 542 on the outside of the source areas 540. The Schottky contacts 530 and the ohmic contact 520 are annealed together in a single processing step at a temperature in excess of 600 °C. The ohmic contact 520 forms a drain terminal 560 of the finished vertical power MOSFET 500.

The power MOSFET 500 shown in Figure 10 has an integrated Schottky contact 530, which may be used by many applications. This has the advantage that no additional device is required to serve as a freewheeling diode. Due to the relatively large bandgap, the turn-on voltage of the body diode lies in excess of 2.5 V. Integrating the Schottky diode into the MOSFET 500 is one option to reduce the turn-on voltage to below 1 V. Contrary to conventional manufacturing methods, the integration of the Schottky contacts 530 into the power MOSFET 500 is simplified, because the thermal budget for formation of the ohmic contact 520 is similar to the thermal budget for the formation of the Schottky contacts 530. The formation of the ohmic contact 520 and the Schottky contacts 530 in the same step, at the same temperature, reduces the integration effort significantly.

It also other allows high temperature steps to be performed after the contact formation shown in Figure 8, for example the formation of further ohmic contacts, the activation of polysilicon, an oxide hardback, etc.

The embodiments shown in Figures 1 to 10 as stated represent exemplary embodiments of improved power semiconductor devices and steps for its manufacturing. Therefore, they do not constitute a complete list of all embodiments according to the improved power semiconductor device and manufacturing method. Actual devices and manufacturing methods may vary from the embodiments shown in terms of materials, processing parameters and processing steps, for example.

### Reference Signs

- 100: power semiconductor device
- 110: SiC structure
- 112: SiC layer
- 114: first main surface
- 116: second main surface
- 120: ohmic contact
- 122: first metal layer
- 130: Schottky barrier contact
- 132: layer stack
- 134: interlayer
- 136: second metal layer

- 400: Schottky barrier diode
- 410: SiC structure
- 412: SiC epilayer
- 414: SiC substrate
- 416: edge termination area
- 420: ohmic contact
- 422: first metal layer
- 430: Schottky barrier contact
- 432: layer stack
- 434: interlayer
- 436: second metal layer

- 500: power MOSFET
- 510: SiC structure
- 512: SiC epilayer
- 514: SiC substrate
- 520: ohmic contact
- 522: first metal layer
- 530: Schottky contact
- 532: layer stack
- 534: interlayer
- 536: second metal layer
- 540: source area
- 542: p+ well
- 544: n+ well
- 550: gate structure
- 552: gate electrode
- 554: interlayer dielectric
- 560: drain terminal

## Claims

1. A power semiconductor device (100), comprising:
― a silicon carbide semiconductor, SiC, structure (110, 410, 510), comprising a SiC layer (112, 412, 512);
― at least one ohmic contact (120, 420, 520) formed on a first main surface (114) of the SiC structure (110, 410, 510); and
― at least one Schottky barrier contact (130, 430, 530) formed on a second main surface (116) of the SiC structure (110, 410, 510), wherein the at least one Schottky barrier contact (130, 430, 530) comprises a metal layer (136, 436, 536) and an carbon group interlayer (134, 434, 534) arranged between the metal layer (136, 436, 536) and the second main surface (116) of the SiC structure (110, 410, 510) .

2. The power semiconductor device (100) of claim 1, wherein the SiC structure (410, 510) comprises an SiC epilayer (412, 512) with a first dopant concentration and a SiC substrate (414, 514) with a second dopant concentration, wherein the second dopant concentration is significantly higher than the first dopant concentration.

3. The power semiconductor device (100) of claim 1 or 2, wherein the SiC layer (112, 412, 512) is a semi-conductive SiC layer having a dopant concentration below 10¹⁷ cm^{―3}, in particular in the range of 10¹³ cm^{―3} to 10¹⁷ cm^{―3}, or a high purity semi-insulating SiC layer having an electrical resistivity of 10⁷ to 10⁹ Ohm cm.

4. The power semiconductor device (100) of any one of claims 1 to 3, wherein the carbon group interlayer (134, 434, 534) has a thickness in the range of 10 to 100 nm.

5. The power semiconductor device (100) of any one of claims 1 to 4, wherein the carbon group interlayer (134, 434, 534) of the at least one Schottky barrier contact (130, 430, 530) comprises at least one of carbon, silicon, germanium, or lead.

6. The power semiconductor device (100) of any one of claims 1 to 5, wherein the metal layer (136, 436, 536) of the at least one Schottky barrier contact (130, 430, 530) comprises at least one of nickel, gold, molybdenum, titanium, or platinum.

7. The power semiconductor device (100) of any one of claims 1 to 6, wherein the at least one ohmic contact (120, 420, 520) comprises one of the following:
- a nickel layer;
- a titanium aluminum, Ti/Al, alloy layer; or
- a Titanium Aluminum Nickel, Ti/Al/Ni, alloy layer.

8. A Schottky barrier diode (400) comprising:
- a power semiconductor device (100) according to one of claims 1 to 7;
- an anode terminal connected to the at least one Schottky barrier contact (430); and
- a cathode terminal connected to the at least one ohmic contact (420).

9. A vertical field effect transistor, in particular a power MOSFET (500), comprising:
- a power semiconductor device (100) according to one of claims 1 to 7;
- a source terminal connected to the at least one Schottky barrier contact (530);
- a drain terminal (560) connected to the at least one ohmic contact (520); and
- a gate terminal connected to an insulated gate electrode (552) arranged on the second main surface (116) of the SiC structure (510).

10. The vertical field effect transistor of claim 9, further comprising at least two highly doped wells (542, 544) arranged within the SiC epilayer (512), wherein the insulated gate electrode (552) is arranged in an area between the at least two highly doped wells (542, 544), and two Schottky barrier contacts (530) are formed adjacent to the at least two highly doped wells (542, 544) .

11. A method for manufacturing a power semiconductor device, comprising:
- forming (S1), in particular epitaxially growing, a Silicon Carbide, SiC, layer (112, 412, 512) of a SiC structure (110, 410, 510);
- depositing (S2) a carbon group interlayer (134, 434, 534) on the SiC layer (112, 412, 512);
- depositing (S3) a first metal layer (122, 422, 522) on a backside of the SiC structure (110, 410, 510); and
- depositing (S4) a second metal layer (136, 436, 536) of a Schottky contact (130, 430, 530) on the carbon group interlayer (134);
- after depositing the first metal layer (122, 422, 522) and the second metal layer (136, 436, 536), annealing (S5) at least the first metal layer (122, 422, 522) at an annealing temperature to form at least one ohmic contact (120) .

12. The method of claim 11, wherein the first metal layer (122, 422, 522) is annealed at an annealing temperature at or above 600 degree centigrade, in particular using rapid thermal treatment for 1 to 10 minutes at a temperature between 600 and 1000 degrees centigrade.

13. The method of claim 11 or 12, wherein in the step of annealing, the carbon group interlayer (134, 434, 534), the first metal layer (122, 422, 522) and the second metal layer (136, 436, 536) are jointly annealed to form, after the annealing, the at least one Schottky barrier contact (130, 430, 530) on a frontside of SiC structure (110, 410, 510) and the at least one ohmic contact (120, 420, 520) on the backside of the SiC structure (110, 410, 510).

14. The method of any one of claims 11 to 13, wherein the carbon group interlayer (134, 434, 534), the first metal layer (122, 422, 522) and/or the second metal layer (136, 436, 536) are deposited using one of electronic beam deposition or thermal evaporation deposition.

15. The method of any one of claims 11 to 14, further comprising, before the step of depositing a carbon group interlayer (534) on the SiC layer (512):
- forming at least one highly doped first well of a first conductivity type, in particular a p+ well (542), within the SiC layer (512); and
- forming at least one highly doped second well of a second conductivity type, in particular a n+ well (544), within the at least one highly doped first well;
- wherein the carbon group interlayer (136) is formed adjacent to the at least one highly doped first well; and
- wherein the SiC layer (112) is a SiC layer of the second conductivity type, in particular a n-type SiC layer (512).
